(19) Europäisches Patentamt / European Patent Office / Office européen des brevets

(11) **EP 3 605 125 B1**

(12) **EUROPEAN PATENT SPECIFICATION**

(45) Date of publication and mention of the grant of the patent:
**08.01.2025 Bulletin 2025/02**

(21) Application number: **18777306.4**

(22) Date of filing: **28.03.2018**

(51) International Patent Classification (IPC):
*G01R 31/36* (2020.01)     *H01M 10/42* (2006.01)
*H01M 10/48* (2006.01)     *H02J 7/00* (2006.01)
*G01R 31/382* (2019.01)     *G01R 31/3842* (2019.01)

(52) Cooperative Patent Classification (CPC):
**G01R 31/3842; G01R 31/36; H01M 10/4285;
H01M 10/48; H01M 10/482; H02J 7/0048;
Y02E 60/10**

(86) International application number:
**PCT/JP2018/013057**

(87) International publication number:
**WO 2018/181624 (04.10.2018 Gazette 2018/40)**

(54) **STORED ELECTRICITY AMOUNT ESTIMATING DEVICE, ELECTRICITY STORAGE MODULE, STORED ELECTRICITY AMOUNT ESTIMATING METHOD, AND COMPUTER PROGRAM**

VORRICHTUNG ZUR SCHÄTZUNG DER GESPEICHERTEN STROMMENGE, STROMSPEICHERMODUL, VERFAHREN ZUR SCHÄTZUNG DER GESPEICHERTEN STROMMENGE UND COMPUTERPROGRAMM

DISPOSITIF D'ESTIMATION DE QUANTITÉ D'ÉLECTRICITÉ STOCKÉE, MODULE DE STOCKAGE D'ÉLECTRICITÉ, PROCÉDÉ D'ESTIMATION DE QUANTITÉ D'ÉLECTRICITÉ STOCKÉE ET PROGRAMME INFORMATIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **29.03.2017   JP 2017064915**

(43) Date of publication of application:
**05.02.2020   Bulletin 2020/06**

(73) Proprietor: **GS Yuasa International Ltd.**
**Kyoto-shi, Kyoto 601-8520 (JP)**

(72) Inventors:
• **UKUMORI, Nan**
  **Kyoto-shi**
  **Kyoto 601-8520 (JP)**
• **IKEDA, Yuichi**
  **Kyoto-shi**
  **Kyoto 601-8520 (JP)**

(74) Representative: **Grünecker Patent- und Rechtsanwälte PartG mbB Leopoldstraße 4 80802 München (DE)**

(56) References cited:
WO-A1-2015/162967     JP-A- 2013 213 808
JP-A- 2015 230 193     US-A1- 2002 113 595
US-A1- 2006 091 863     US-A1- 2009 210 179
US-A1- 2010 213 946     US-A1- 2015 355 285
US-A1- 2016 254 542     US-B1- 9 500 713

## Description

TECHNICAL FIELD

The present invention relates to a storage amount estimation device that estimates a storage amount such as SOC (State Of Charge) of an energy storage device, an energy storage module including the storage amount estimation device, a storage amount estimation method, and a computer program.

BACKGROUND ART

There is a demand for high capacity in a secondary battery for vehicle used in an electric vehicle, a hybrid vehicle, and an industrial secondary battery used in a power storage device, a solar power generating system, and the like. Various investigations and improvements have been made so far, and it is difficult to achieve a higher capacity only by improving an electrode structure and the like. For this reason, development of a positive electrode material having a higher capacity than the current material is underway.

Conventionally, a lithium transition metal composite oxide having an $\alpha$-NaFeO$_2$ type crystal structure have been studied as a positive active material for a nonaqueous electrolyte secondary battery such as a lithium ion secondary battery, and a nonaqueous electrolyte secondary battery in which LiCoO$_2$ is used has widely been used. A discharge capacity of LiCoO$_2$ ranged from about 120 mAh/g to about160 mAh/g.

When the lithium transition metal composite oxide is represented by LiMeO$_2$ (Me is a transition metal), desirably Mn was used as Me. In a case where a molar ratio Mn/Me of Mn in Me exceeds 0.5 with Mn contained as Me, a structure changes to a spinel type when charge is performed, and a crystal structure cannot be maintained. For this reason, charge-discharge cycle performance is significantly inferior.

Various LiMeO$_2$ type active materials in which the molar ratio Mn/Me of Mn in Me is less than or equal to 0.5 and the molar ratio Li/Me of Li to Me is substantially 1 have been proposed and put into practical use. A positive active material containing LiNi$_{1/2}$Mn$_{1/2}$O$_2$ and LiNi$_{1/3}$Co$_{1/3}$Mn$_{1/3}$O$_2$, which are the lithium transition metal composite oxide, has the discharge capacity of 150 mAh/g to 180 mAh/g.

In contrast to the LiMeO$_2$ type active material, there is known what is called a lithium-excess active material containing a lithium transition metal composite oxide in which the molar ratio Mn/Me of Mn in Me exceeds 0.5 and the composition ratio Li/Me of Li to the ratio of transition metal (Me) is greater than 1.

A lithium-excess type Li$_2$MnO$_3$-based active material has been studied as the high-capacity positive electrode material. This material has a property of a hysteresis in which a voltage value and an electrochemical characteristic with respect to the same SOC (State Of Charge) change depending on a charge history and a discharge history.

A method for estimating the SOC in a secondary battery includes an OCV method (voltage reference) for determining the SOC based on a correlation (SOC-OCV curve), in which the OCV (Open Circuit Voltage) and the SOC of the secondary battery are correlated with each other in a one-to-one manner, and a current integration method for determining the SOC by integrating a charge-discharge current value of the secondary battery.

When an electrode material having the hysteresis is used, it is difficult to estimate the SOC by the OCV method because the voltage value is not uniquely decided with respect to the SOC. Because the SOC-OCV curve is not uniquely decided, it is difficult to predict dischargeable energy at a certain point of time.

When the SOC is calculated by the current integration method, the following equation (1) is used.

$$\mathrm{SOC_i = SOC_{i\text{-}1} + I_i \times \Delta t_i / Q \times 100 \ ... \ (1)}$$

SOC$_i$: current SOC
SOC$_{i-1}$: previous SOC
I: current value
$\Delta t$: time interval
Q: battery capacity (available capacity)

When the current integration is continued for a long time, a measurement error of the current sensor is accumulated. Because the battery capacity decreases with time, an estimation error of the SOC estimated by the current integration method increases with time. Conventionally, an OCV reset in which the SOC is estimated by the OCV method to reset the error accumulation is performed when the current integration is continued for a long time.

Also in the energy storage device in which the electrode material having the hysteresis is used, an error is accumulated when the current integration is continued. However, because the voltage value is not uniquely decided with respect to the SOC, it is difficult to estimate the SOC by the OCV method (to perform the OCV reset).

Thus, it is difficult to accurately estimate the SOC in the energy storage device by the current SOC estimation technique.

In a secondary battery control device disclosed in Patent Document 1, a relationship between the SOC and the OCV in a discharge process is stored as discharging OCV information for each switching SOC that is the SOC when the charge is switched to the discharge. The secondary battery control device is configured to calculate the SOC in the discharge process of the secondary battery based on the switching SOC when the charge is actually switched to the discharge and the discharging OCV information.

PRIOR ART DOCUMENT

PATENT DOCUMENT

Patent Document 1: JP-A-2013-105519

US 2006/091863 A1 relates to a battery control for use with a battery, which includes a voltage measuring module that measures battery voltage, a current measuring module that measures battery current, and a state of charge (SOC) module that communicates with said current and voltage measuring modules. In some features, the SOC module determines an unfiltered SOC of said battery, a characteristic of said unfiltered SOC, and a modified SOC that is based on said unfiltered SOC and said characteristic. In other features, the SOC module determines first and second reset voltages, compares the battery voltage to the first and second reset voltages, and determines an unfiltered SOC based on said first and second reset voltages and said battery voltage.

US 2015/355285 A1 relates to a state-of-charge estimation device and method, that estimate a state of charge in a battery having a large polarization, requiring a long time for depolarization, and having a large charge-/discharge hysteresis in its SOC-OCV characteristics. The state-of-charge estimation device includes a voltage measuring unit, which measures a closed circuit voltage in a battery, a charge estimation unit, which estimates a state of charge in a charge mode by referring to charge mode information that associates a closed circuit voltage with a state of charge in the battery, and a discharge estimation unit, which estimates a state of charge in a discharge mode by referring to discharge mode information that associates a closed circuit voltage generated by use of a discharge pattern of the battery with a state of charge in the battery by use of the measured closed circuit voltage.

US 2002/113595 A1 discloses a battery control system, which charges or discharges a storage battery installed in a hybrid vehicle to bring a state-of-charge of the storage battery into agreement with a target one. The system determines whether the state-of-charge lies within a given narrower range defined around the target state-of-charge and corrects the state-of-charge based on an open-circuit voltage of the battery when the state-of-charge lies within the given narrower range, thereby eliminating a cumulative error in calculating the state-of-charge of the battery caused by a variation in charge-/discharge efficiency of the battery.

US 2016/254542 A1 discloses a lithium ion secondary battery, the charged state of which can be detected from the battery voltage with high accuracy, and which is able to achieve a high capacity in a high-potential range. For this purpose a cathode active material for lithium ion secondary batteries is used, which is composed of a lithium transition metal oxide containing Li and metal elements including at least Ni and Mn, and wherein the atomic ratio of Li to the metal elements satisfies $1.15 < Li/(\text{metal elements}) < 1.5$; the atomic ratio of Ni to Mn satisfies $0.334 < Ni/Mn \leqq 1$; and the atomic ratio of Ni and Mn to the metal elements satisfies $0.975 \leqq (Ni+Mn)/(\text{metal elements}) \leqq 1$.

US 2010/213946 A1 discloses a method of estimation of the state of charge of a lead acid battery, which comprises measuring the open circuit voltage difference between an integrated liquid junction reference electrode and a negative battery terminal during at least one cut-off period, and determining the state of charge on the basis of the open circuit voltage difference and one of a charge or a discharge calibration curve.

SUMMARY OF THE INVENTION

PROBLEMS TO BE SOLVED BY THE INVENTION

In the secondary battery control device of Patent Document 1, the SOC-OCV curve during the discharge is selected from the voltage values reached by the charge, and the SOC is estimated based on the SOC-OCV curve and the current voltage value. In the secondary battery control device, the SOC cannot be estimated based on the voltage value of a charge process. When the charge-discharge is repeated with a complicated pattern, the secondary battery can hardly be monitored with high accuracy.

An object of the present invention is to provide a storage amount estimation device that can estimate a storage amount of an energy storage device containing an active material in which a storage amount-voltage value characteristic exhibits a hysteresis, an energy storage module including the storage amount estimation device, a storage amount estimation method, and a computer program.

As used herein, the storage amount means the SOC, a power dischargeable amount, and the like.

MEANS FOR SOLVING THE PROBLEMS

This object is achieved by the present invention as claimed in the independent claims. Advantageous and preferred embodiments of the present invention are defined by the dependent claims.

Examples, aspects and embodiments presented in the following and not necessarily falling under the scope of the claims are provided in the application to better understand the invention.

According to one example, a storage amount estimation device that estimates a storage amount of an energy storage device in which at least one of a positive electrode and a negative electrode contains an active material, at least two electrochemical reactions being generated in the active material depending on a transition of charge-discharge, a hysteresis of a storage amount-voltage value characteristic indicated during generation of one of the electrochemical reactions is smaller than a hysteresis during generation of the other electrochemical reaction in the active material, the storage amount estimation device includes an estimator that estimates the storage amount based on the storage amount-voltage value characteristic when the one electrochemical reaction is generated more than the other electrochemical reaction.

As used herein, "when one electrochemical reaction is generated" includes "when a group of electrochemical reactions simultaneously take place". "When the other electrochemical reaction occurs" includes "when a group of electrochemical reactions simultaneously take place".

ADVANTAGES OF THE INVENTION

The inventors have found that a reaction having the large hysteresis and a reaction having the small hysteresis are substantially independently generated in the energy storage device in which the electrode material having the hysteresis is used, and conceived the above configuration. This knowledge has not conventionally been known, and has been newly found by the inventors.

According to the present invention, the storage amount can be estimated based on the voltage value in any one of charging and discharging processes, or even in the case where the charge-discharge is repeated in a complicated pattern.

Because of the use of the voltage value, the storage amount is not limited to the SOC, and the current amount of energy, such as amount of power, which is stored in the battery, can be estimated. The dischargeable energy up to SOC 0% and the charge energy required up to SOC 100% can be predicted based on a charge-discharge curve.

BRIEF DESCRIPTION OF THE DRAWINGS

Fig. 1 is a graph illustrating a result in which a relationship between an electric quantity and a charge-discharge voltage value is obtained with respect to a Li-excess active material.
Fig. 2 is a graph illustrating a transition of K absorption edge energy of Ni in a Li-excess active material calculated by X-ray absorption spectroscopy (XAFS measurement) with respect to the electric quantity.
Fig. 3 is a graph illustrating the transition of the K absorption edge energy of Ni during charge-discharge.
Fig. 4 is a graph illustrating the result in which the relationship between the electric quantity and the charge-discharge voltage value is obtained with respect to an energy storage device including a negative electrode containing an active material exhibiting a hysteresis.
Fig. 5 illustrates an example of a charge-discharge curve when a region having a large hysteresis and a region having a small hysteresis appear alternately with increasing SOC (State Of Charge).
Fig. 6 is a perspective view illustrating an example of an energy storage module.
Fig. 7 is a perspective view illustrating another example (battery module) of the energy storage module.
Fig. 8 is an exploded perspective view of the battery module in Fig. 7.
Fig. 9 is a block diagram of the battery module.
Fig. 10 is a flowchart illustrating a procedure of SOC estimation processing performed by a CPU.
Fig. 11 is a flowchart illustrating the procedure of the SOC estimation processing performed by the CPU.
Fig. 12 is a graph illustrating the transition of a voltage value with respect to time during the charge-discharge.
Fig. 13 is a graph which illustrating the transition of the SOC calculated by voltage reference until the SOC reaches E3 V in first discharge and second charge, and until the SOC changes from E1 V of second discharge to a lower limit voltage value E0 V.
Fig. 14 is a graph illustrating the transition of the SOC when the SOC is calculated by current integration in the transition of the charge-discharge voltage value in Fig. 12.
Fig. 15 is a graph illustrating a difference between estimation of the SOC by the voltage reference of the embodiment and estimation of the SOC by the current integration when the charge-discharge in Fig. 12 is performed on a battery of an initial product.
Fig. 16 is a graph illustrating the difference between the estimation of the SOC by the voltage reference and the estimation of the SOC by the current integration when the charge-discharge is performed with a pattern different from one in Fig. 12 on the battery of the initial product.
Fig. 17 is a graph illustrating the difference between the estimation of the SOC by the voltage reference and the estimation of the SOC by the current integration when the charge-discharge is performed with the pattern different from one in Fig. 12 on the battery of the initial product.
Fig. 18 is a graph illustrating the difference between the estimation of the SOC by the voltage reference and the estimation of the SOC by the current integration when the charge-discharge in Fig. 12 is performed on a battery of a degraded product.
Fig. 19 is a graph illustrating the difference between the estimation of the SOC by the voltage reference and the estimation of the SOC by the current integration when the charge-discharge is performed with the pattern identical to one in Fig. 16 on the battery of the degraded product.
Fig. 20 is a graph illustrating the difference between the estimation of the SOC by the voltage reference and the estimation of the SOC by the current integration when the charge-discharge is performed with the pattern identical to one in Fig. 17 on the battery of the degraded product.

Fig. 21 is a flowchart illustrating a procedure of SOC estimation processing performed by a CPU.

Fig. 22 is a flowchart illustrating the procedure of the SOC estimation processing performed by the CPU.

## MODE FOR CARRYING OUT THE INVENTION

Hereinafter, the present invention will be specifically described based on the drawings illustrating embodiments of the present invention.

(Outline of embodiment)

An electrode assembly of an energy storage device according to the embodiment contains an active material in which a storage amount-voltage value characteristic has a hysteresis.

Hereinafter, the case where the active material of the energy storage device is a Li-excess $LiMeO_2$-$Li_2MnO_3$ solid solution containing Ni and an electric quantity is the SOC will be described as an example.

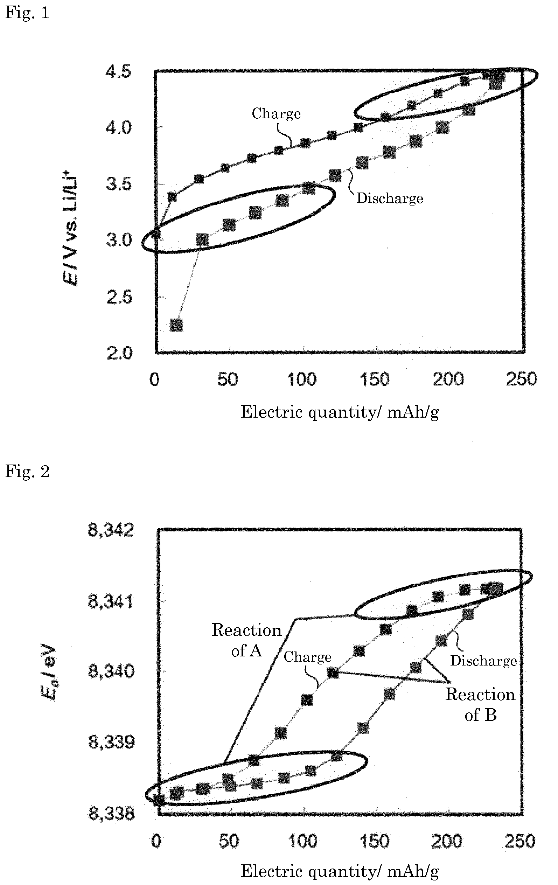

Fig. 1 is a graph illustrating a result in which a relationship between an electric quantity and a charge-discharge voltage value is obtained using a lithium cell of a counter electrode Li with respect to a Li-excess active material. A horizontal axis indicates the electric quantity (mAh/g), and a vertical axis indicates a charge-discharge voltage value ($VvsLi/Li^+$: $Li/Li^+$ potential difference based on the equilibrium potential). At this point, the electric quantity corresponds to the SOC.

As illustrated in Fig. 1, an increase (charge) in SOC and a decrease (discharge) in SOC differ from each other in the voltage value. That is, the voltage values for the same SOC are different from each other, and have the hysteresis. For the active material, a high SOC region is smaller than a low SOC region in the potential difference with respect to the same SOC, and the hysteresis is small.

In the embodiment, a region where the hysteresis is small and the SOC can be estimated from the voltage value using an SOC-OCV curve is determined, and the SOC is estimated in the region.

Fig. 2 is a graph illustrating a transition of K absorption edge energy of Ni in the Li-excess active material calculated by X-ray absorption spectroscopy (XAFS measurement) with respect to the electric quantity. The horizontal axis indicates the electric quantity (mAh/g), and the vertical axis indicates K absorption edge energy $E_0$ (eV) of Ni.

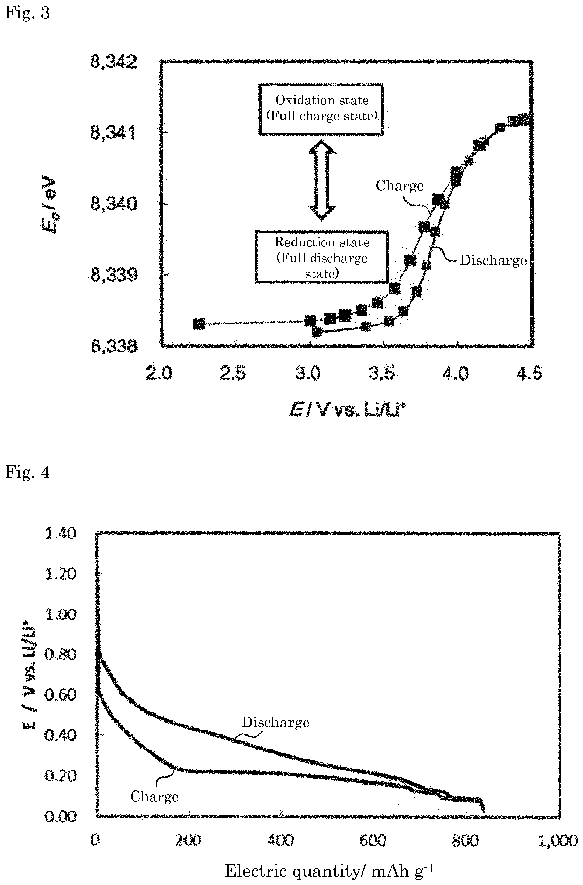

Fig. 3 is a graph illustrating the transition of the K absorption edge energy of Ni during charge-discharge. The horizontal axis indicates the charge-discharge voltage value ($VvsLi/Li^+$), and the vertical axis indicates the K absorption edge energy $E_0$ (eV) of Ni.

As illustrated in Fig. 2, in the high SOC region, the transition of the K absorption edge energy of Ni in a charge reaction is not matched with the transition of the energy in a discharge reaction. In the low SOC region, the transition of the energy in the discharge reaction is not matched with the transition of the energy in the charge reaction. That is, it can be seen that a redox reaction except for Ni that has the hysteresis is mainly generated (it is assumed that this reaction is A). The reaction of A is an oxidation reaction in the high SOC region, and is a reductive reaction in the low SOC region.

In a middle SOC region, the K absorption edge energy of Ni in the charge reaction and discharge reaction changes substantially linearly with respect to the SOC.

As illustrated in Fig. 3, in the high SOC region where the charge-discharge voltage value ranges substantially from 3.7 V to 4.5 V, the charge and the discharge are substantially matched with each other in the K absorption edge energy of Ni. When the K absorption edge energy of Ni is the same, it is considered that a valence of Ni is equal, that a valence change of Ni corresponds substantially to a voltage value of at 1:1 in this voltage range, and that Ni reacts reversibly. That is, in the SOC region, the redox reaction having a small hysteresis indicated by the SOC-OCP characteristic is mainly generated (it is assumed that this reaction is B). The OCP means an open circuit potential.

In the SOC region, a reaction amount of B is larger than a reaction amount of A, and resultantly the hysteresis is smaller than that in the low SOC region.

In the embodiment, the lower voltage value (lower limit voltage value) in the region where the reaction of B is mainly generated is obtained by an experiment. At the lower limit voltage value, existence of the hysteresis is substantially switched. The oxidation amount and the reduction amount of the reaction of B are considered to be small.

When a determination that a charge state or a discharge state exists in a region corresponding to a voltage region that is greater than or equal to the lower limit voltage value is made based on the increase and decrease of the voltage value, the SOC is estimated by the voltage reference based on a reached voltage value.

In this case, the description is given by focusing only on the oxidation-reduction reaction of Ni. However, the reaction of B is not limited to the oxidation-reduction reaction of Ni. The reaction of B refers to a reaction with the small hysteresis of the storage amount-voltage value characteristic in one or a group of reactions generated by the active material according to the transition of the charge-discharge.

The case where the negative electrode of the energy storage device contains the active material having the large hysteresis will be described below. The case where the negative electrode includes SiO and graphite as active materials will be described as an example. The hysteresis generated during the electrochemical reaction of SiO is larger than the hysteresis generated during the electrochemical reaction of graphite.

Fig. 4 is a graph illustrating a result in which the relationship between the electric quantity and the charge-discharge voltage value is obtained using the lithium cell of the counter electrode Li with respect to the energy storage device. A horizontal axis indicates the electric quantity (mAh/g), and a vertical axis indicates a charge-discharge voltage value (VvsLi/Li$^+$: Li/Li$^+$ potential difference based on the equilibrium potential). At this point, the electric quantity corresponds to the SOC.

As illustrated in Fig. 4, the charge curve and the discharge curve differ from each other in the voltage value. That is, the voltage values for the same SOC are different from each other, and have the hysteresis. For the active material, a high SOC region is smaller than a low SOC region in the potential difference with respect to the same SOC, and the hysteresis is small.

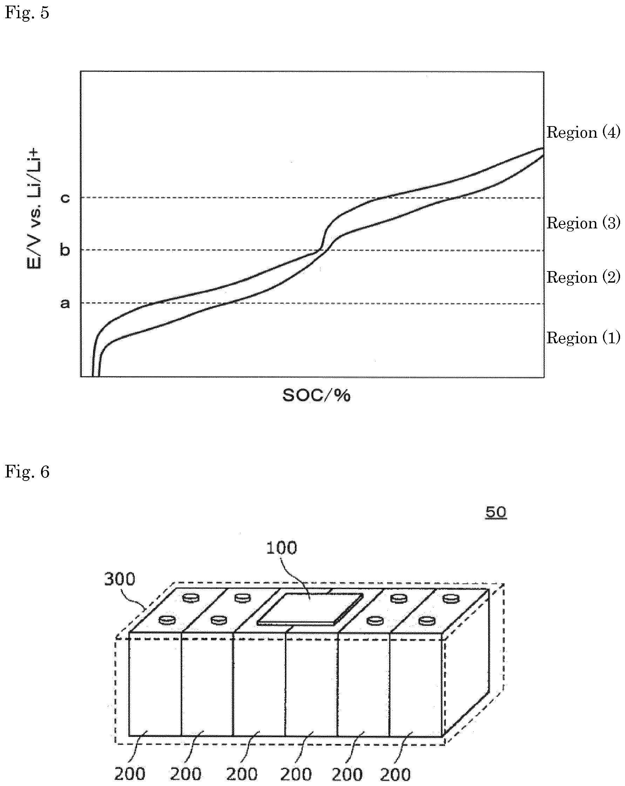

Fig. 5 illustrates the charge-discharge curve when the region having the large hysteresis and the region having the small hysteresis appear alternately with increasing SOC (or voltage value). A horizontal axis indicates SOC (%), and a vertical axis indicates a voltage value (V).

When the positive electrode contains a plurality of Li-excess active materials having different positive electrodes, when the negative electrode contains a plurality of active materials having the large hysteresis, and when each of the positive electrode and the negative electrode contains the active material having the large hysteresis, sometimes the region having the large hysteresis and the region having the small hysteresis appear alternately, or appear while overlapping each other.

In a region (2) where the voltage value ranges from a to b in Fig. 5, the hysteresis is smaller than that in a region (1) where the voltage value is less than or equal to a. A reaction of C having the large hysteresis and a reaction of D having the small hysteresis are generated in the region (2). Because the reaction amount of D is large in the region (2), the hysteresis is smaller than that in the region (1) as a result.

In a region (4) where the voltage value is greater than or equal to c in Fig. 5, the hysteresis is smaller than that in the region (3) where the voltage value ranges from b to c. A reaction of E having the large hysteresis and a reaction of F having the small hysteresis are generated in the region (4). Because the reaction amount of E is large in the region (4), the hysteresis is smaller than that in the region (3) as a result.

The lower limit voltage value a in the region (2) and the lower limit voltage value c in the region (4) are obtained by the experiment. When the determination that the charge state or discharge state exists in the region (2) corresponding to the voltage region greater than or equal to the lower limit voltage value a is made based on the increase or decrease of the voltage value, and when the determination that the charge state or discharge state exists in the region (4) corresponding to the voltage region greater than or equal to the lower limit voltage value c is made based on the increase or decrease of the voltage value, the SOC is estimated by the voltage reference based on the reached voltage value (to be described later).

The region of the voltage value is not limited to the case where the region of the voltage value is divided into two or four regions as described above. When a plurality of electrochemical reactions is generated depending on the active material of the positive electrode or negative electrode to cause the region having the large hysteresis and the region having the small hysteresis to appear alternately, the SOC is relatively high and the SOC is estimated by the voltage reference in the region where the SOC is relatively high and the hysteresis is small.

(First embodiment)

A first embodiment will be described below by taking an energy storage module mounted on a vehicle as an example.

Fig. 6 illustrates an example of the energy storage module. An energy storage module 50 includes a plurality of energy storage devices 200, a monitoring device 100, and a housing case 300 that stores the plurality of energy storage devices 200 and the monitoring device 100. The energy storage module 50 may be used as a power source for an electric vehicle (EV) or a plug-in hybrid electric vehicle (PHEV).

The energy storage device 200 is not limited to a prismatic cell, but may be a cylindrical cell or a pouch cell.

The monitoring device 100 may be a circuit board disposed opposite to the plurality of energy storage devices 200. The monitoring device 100 monitors a state of the energy storage device 200. The monitoring device 100 may be a storage amount estimation device. Alternatively, a computer or a server that is connected to the monitoring device 100 in a wired or wireless manner may perform a storage amount estimation method based on information output from the monitoring device 100.

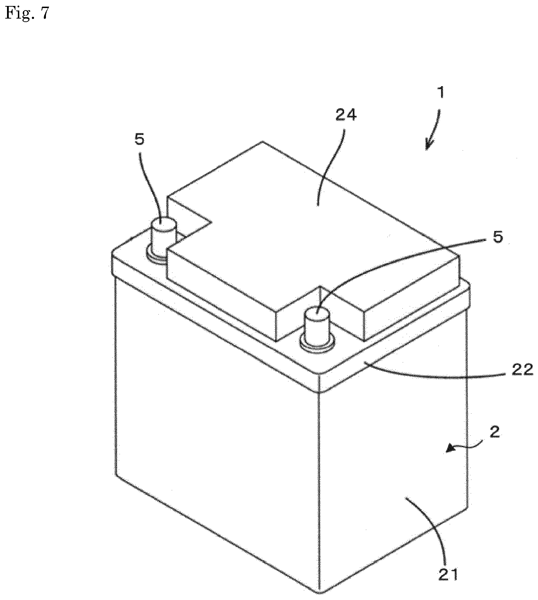

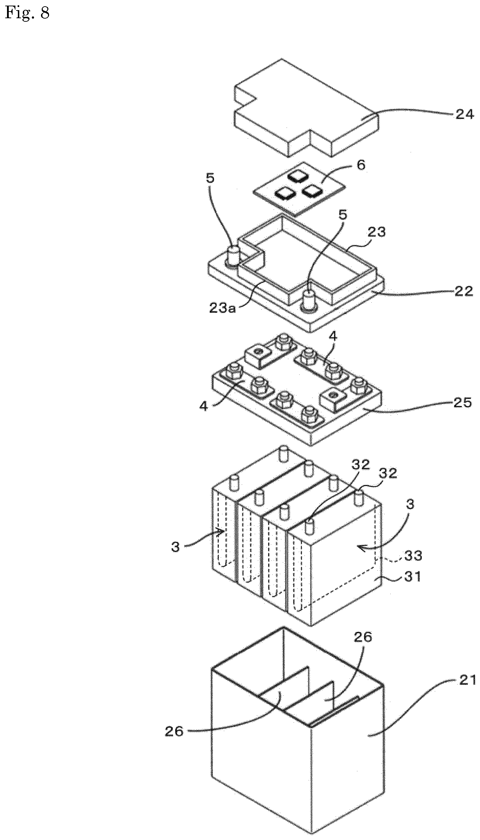

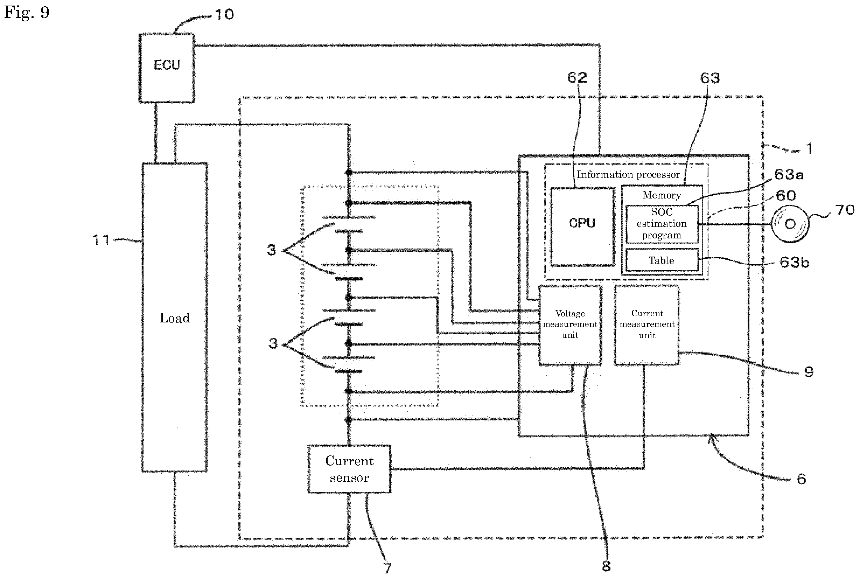

Fig. 7 illustrates another example of the energy storage module. The energy storage module (hereinafter, referred to as a battery module) 1 may be a 12-volt power supply or a 48-volt power supply that is suitably mounted on an engine vehicle. Fig. 7 is a perspective view of the battery module 1 for the 12-V power supply, Fig. 8 is an exploded perspective view of the battery module 1, and Fig. 9 is a block diagram of the battery module 1.

The battery module 1 has a rectangular parallelepiped case 2. A plurality of lithium ion secondary batteries (hereinafter referred to as batteries) 3, a plurality of bus bars 4, a BMU (Battery Management Unit) 6, and a current sensor 7 are accommodated in the case 2.

The battery 3 includes a rectangular parallelepiped case 31 and a pair of terminals 32, 32 that is provided on one side surface of the case 31 and having different polarities. The case 31 houses an electrode assembly 33 in which a positive electrode plate, a separator, and a negative electrode plate are laminated.

At least one of a positive active material included in the positive electrode plate and a negative active material included in the negative electrode plate of the electrode assembly 33 generates at least two electrochemical reactions depending on a transition of charge-discharge. A hysteresis of a storage amount-voltage value characteristic exhibiting during the generation of one electrochemical reaction is smaller than a hysteresis during the generation of the other electrochemical reaction.

Examples of the positive active material include Li-excess active materials such as the above $LiMeO_2$-$Li_2MnO_3$ solid solution, a $Li_2OLiMeO_2$ solid solution, a $Li_3NbO_4$-$LiMeO_2$ solid solution, a $Li_4WO_5$-$LiMeO_2$ solid solution, a $Li_4TeO_5$-$LiMeO_2$ solid solution, a $Li_3SbO_4$-$LiFeO_2$ solid solution, a $Li_2RuO_3$-$LiMeO_2$ solid solution, and a $Li_2RuO_3$-$Li_2MeO_3$ solid solution. Examples of the negative active materials include hard carbon, metals such as Si, Sn, Cd, Zn, Al, Bi, Pb, Ge, and Ag or alloys thereof, or chalcogenides containing these. SiO can be cited as an example of the chalcogenide. The technique of the present invention is applicable as long as at least one of the positive active materials and negative active materials is contained.

The case 2 is made of a synthetic resin. The case 2 includes a case body 21, a lid 22 that closes an opening of the case body 21, a BMU housing 23 provided on an outer surface of the lid 22, a cover 24 covering the BMU housing 23, an inner lid 25, and a partition plate 26. The inner lid 25 and the partition plate 26 may not be provided.

The battery 3 is inserted between the partition plates 26 of the case body 21.

A plurality of metal bus bars 4 are placed on the inner lid 25. The inner lid 25 is disposed on a terminal surface on which the terminal 32 of the battery 3 is provided, the adjacent terminals 32 of the adjacent batteries 3 are connected to each other by the bus bar 4, and the batteries 3 are connected in series.

The BMU housing 23 has a box shape, and includes a protrusion 23a protruding outward in a prismatic shape in a central portion of one long side surface. A pair of external terminals 5, 5 that are made of metal such as a lead alloy and has different polarities is provided on both sides of the protrusion 23a in the lid 22. The BMU 6 is configured by mounting an information processor 60, a voltage measuring unit 8, and a current measuring unit 9 on a substrate. The BMU 6 is housed in the BMU housing 23 and the BMU housing 23 is covered with the cover 24, whereby the battery 3 and the BMU 6 are connected to each other.

As illustrated in Fig. 9, the information processor 60 includes a CPU 62 and a memory 63.

The memory 63 stores an SOC estimation program 63a of the first embodiment and a table 63b in which a plurality of SOC-OCV curves (data) are stored. For example, the SOC estimation program 63a is provided while stored in a computer-readable recording medium 70 such as a CD-ROM, a DVDROM, and a USB memory, and the SOC estimation program 63a is stored in the memory 63 by installing the SOC estimation program 63a on the BMU 6. Alternatively, the SOC estimation program 63a may be acquired from an external computer (not illustrated) connected to a communication network, and stored in the memory 63.

The CPU 62 performs an SOC estimation processing (to be described later) according to the SOC estimation program 63a read from the memory 63.

The voltage measuring unit 8 is connected to both ends of the battery 3 via a voltage detection line, and measures the voltage value of each battery 3 at predetermined time intervals.

The current measuring unit 9 measures a current value passed through the battery 3 via the current sensor 7 at predetermined time intervals.

The external terminals 5, 5 of the battery module 1 are connected to a starter motor that starts the engine and a load 11 such as an electric component.

An ECU (Electronic Control Unit) 10 is connected to the BMU 6 and the load 11.

Hereinafter, the above one active material will be described on the assumption that the reaction of B is frequently generated at SOC of 40% or more and the corresponding lower limit voltage value of E0 V is obtained by a charge-discharge experiment. A high-SOC region where the SOC is greater than or equal to 40% corresponds to the first region.

When the OCV can be measured as the lower limit voltage value, the lower limit voltage value may be constant. When a CCV (Closed Circuit Voltage) is measured as the lower limit voltage value, update may be performed by lowering the lower limit voltage value according to a degree of degradation associated with the use of the energy storage device. An increase in internal resistance and an increase in deviation of capacity balance can be cited as an example of a cause of the degradation of the energy storage device. The deviation of the capacity balance means that a difference between an amount of side reaction except for a charge-discharge reaction in the positive electrode and an amount of side reactions except for the charge-discharge reaction in the negative electrode is generated to incompletely charge one of the positive electrode and the negative electrode, and the positive and negative electrodes have different capacities in which charged ions can reversibly enter and leave the electrode. In a typical lithium ion battery, because the side reaction amount in the positive electrode is smaller than the side reaction amount in the negative electrode, when the "deviation of capacity balance" increases, the negative electrode cannot fully be charged and the electric quantity that can be reversibly taken out from the energy storage device decreases.

After the battery is charged and the voltage value exceeds the lower limit voltage value, the reached maximum voltage value is taken as the reached voltage value.

The table 63b of the memory 63 stores a plurality of SOC-OCV curves from the lower limit voltage value to a plurality of reached voltage values. For example, an SOC-OCV curve b from the lower limit voltage value E0 V to the reached voltage value E1 V, an SOC-OCV curve c from the lower limit voltage value E0 V to the reached voltage value E2 V, and an SOC-OCV curve d from the lower limit voltage value E0 V to a reached voltage value E3 V are stored in the table 63b. At this point, E1 > E2 > E3 holds. Although also referred to in a comparative test (to be described later), the SOC-OCV curves b, c, d are not illustrated in the drawings. In the table 63b, the SOC-OCV curves corresponding to all the reached voltage values are stored not discretely, but continuously. Instead of storing continuously the SOC-OCV curves, based on the adjacent SOC-OCV curves, a SOC-OCV curve to be located between the SOC-OCV curves may be obtained by interpolation calculation, and the SOC may be estimated from the voltage value and the obtained SOC-OCV curve.

A method for obtaining the SOC-OCV curve for the voltage reference will be described below.

A discharge OCV curve and a charge OCV curve are obtained when SOC (%) is changed from 40% to 100% for each point of SOC (%) from 40% to 100%. The discharge OCV curve can be obtained by passing a minute current in the discharge direction and measuring the voltage value at that time. Alternatively, the discharge is performed from the charge state to each SOC and stopped, and the stable voltage value is measured. Similarly, the charge OCV curve can be obtained when the above measurement is performed in a charge direction. Preferably the OCV curve obtained by averaging a discharge OCV curve and a charge OCV curve is used because the active material has the slight hysteresis even if the SOC is greater than or equal to 40%. The discharge OCV curve and the charge OCV curve, or corrected those may be used.

After a discharge OCP curve and a charge OCP curve are obtained, the discharge OCP curve and the charge OCP curve may be corrected to the SOC-OCV curve for the voltage reference of the battery 3.

The SOC-OCV curve may previously be stored in the table 63b, or updated at predetermined time intervals in consideration of the degradation of the battery 3.

The SOC-OCV curve is not limited to the case where the SOC-OCV curve is stored in the table 63b, but may be stored in the memory 63 as a function expression.

The SOC estimation method of the first embodiment will be described below.

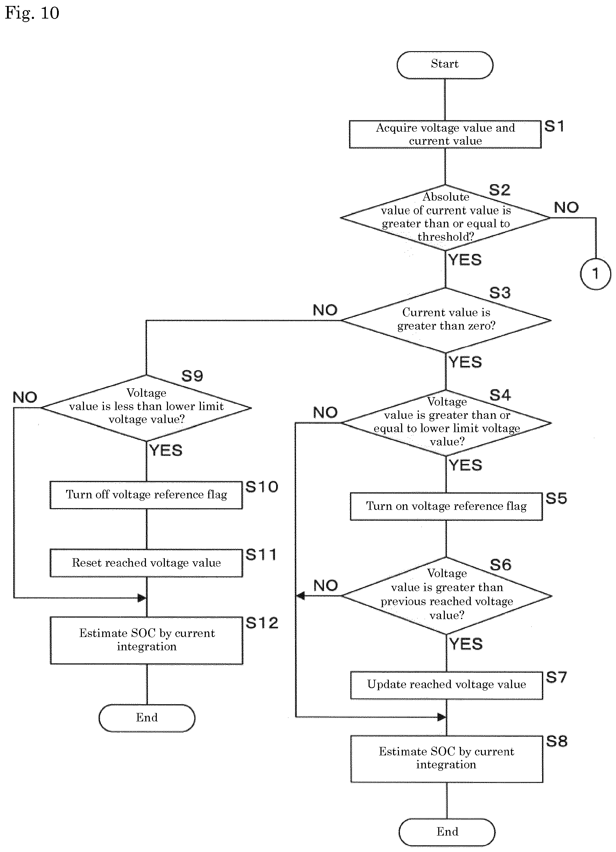

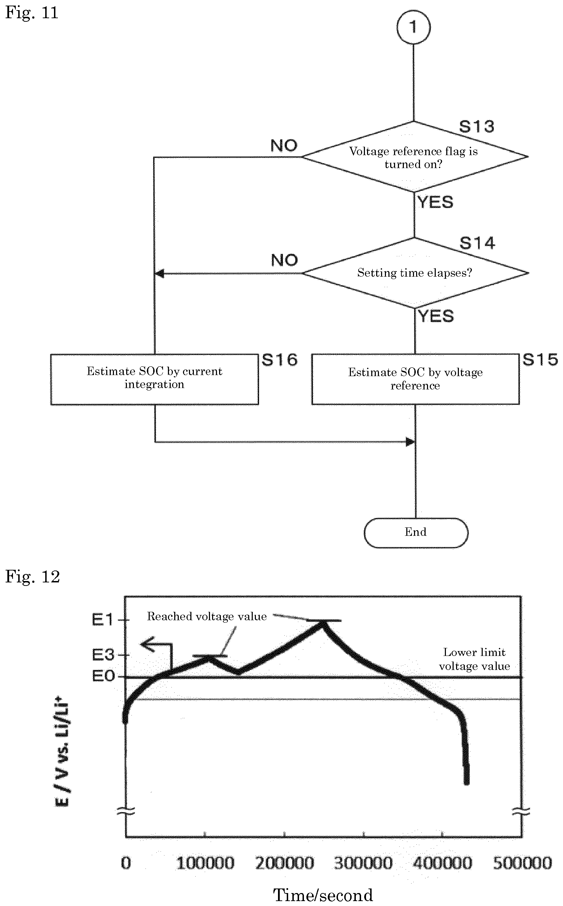

Figs. 10 and 11 are a flowchart illustrating a procedure of the SOC estimation processing performed by the CPU 62. The CPU 62 repeats the pieces of processing from S1 at predetermined or appropriate time intervals.

The CPU 62 acquires the voltage value and the current value between the terminals of the battery 3 (S1). Because the lower limit voltage value and the reached voltage value (to be described later) are the OCV, it is necessary to correct the acquired voltage value to OCV when the current amount of the battery 3 is large. The correction value to OCV is obtained by estimating the voltage value at the current value of zero using a regression line from the data of the pluralities of voltage values and current values. When the amount of current passed through the battery 3 is as small as a dark current (the minute current of claim 6), the acquired voltage value can be regarded as the OCV.

The CPU 62 determines whether an absolute value of the current value is greater than or equal to a threshold (S2). The threshold is set in order to determine whether the battery 3 is in a charge state, a discharge state, or a resting state. When the CPU 62 determines that the absolute value of the current value is less than the threshold (NO in S2), the processing proceeds to S13.

When the CPU 62 determines that the absolute value of the current value is greater than or equal to the threshold (YES in S2), the CPU 62 determines whether the current value is greater than zero (S3). It is determined that the battery 3 is in the charge state when the current value is larger than zero. When the CPU 62 determines that the current value is less than zero (NO in S3), the processing proceeds to S9.

When determining that the current value is greater than zero (YES in S3), the CPU 62 determines whether the voltage value is greater than or equal to the lower limit voltage value (S4). When the CPU 62 determines that the voltage value is less than the lower limit voltage value (NO in S4), the processing proceeds to S8.

When determining that the voltage value is greater than or equal to the lower limit voltage value (YES in S4), the CPU 62 turns on a voltage reference flag (S5).

The CPU 62 determines whether the acquired voltage value is greater than the previous reached voltage value (S6). When the CPU 62 determines that the voltage value is not greater than the previous reached voltage value (NO in S6), the processing proceeds to S8.

When determining that the voltage value is greater than the previous reached voltage value (YES in S6), the CPU 62 updates the voltage value to the reached voltage value in the memory 63 (S7).

The CPU 62 estimates the SOC by the current integration (S8), and ends the processing.

When determining that the current value is less than zero while the battery 3 is in the discharge state, the CPU 62 determines whether the voltage value is less than the lower limit voltage value in S9 (S9). When the CPU 62 determines that the voltage value is greater than or equal to the lower limit voltage value (NO in S9), the processing proceeds to S12.

When determining that the voltage value is less than the lower limit voltage value (YES in S9), the CPU 62 turns off the voltage reference flag (S10).

The CPU 62 resets the reached voltage value (S11).

The CPU 62 estimates the SOC by the current integration (S12), and ends the processing.

When determining that the absolute value of the current value is less than the threshold while the battery 3 is in the resting state, the CPU 62 determines whether the voltage reference flag is turned on (S13). When the CPU 62 determines that the voltage reference flag is not turned on (NO in S13), the processing proceeds to S16.

When determining that the voltage reference flag is turned on (YES in S13), the CPU 62 determines whether a setting time elapses since the battery 3 is determined to be in the resting state in S2 (S14). As for the setting time, a sufficient time for considering the acquired voltage value as the OCV is previously obtained by an experiment. It is determined whether the setting time exceeds the time based on the number of acquisition times and the acquisition interval of the current value after the battery 3 is determined to be in the resting state. Consequently, the SOC can be estimated with higher accuracy in the resting state.

When the CPU 62 determines that the setting time does not elapse (NO in S14), the processing proceeds to S16.

The CPU 62 estimates the SOC by the current integration in S16, and ends the processing.

When the CPU 62 determines that the setting time elapses (YES in S14), the acquired voltage value can be regarded as the OCV, and the SOC is estimated by the voltage reference (S15), and the processing is ended. The CPU 62 selects one SOC-OCV curve from the table 63b based on the reached voltage value stored in the memory 63. When the charge-discharge is repeated, the voltage value rises and falls, namely, a high inflection point among inflection points where the charge is switched to the discharge is set to the reached voltage value. The SOC corresponding to the voltage value acquired in S1 is read in the SOC-OCV curve.

The voltage value acquired from the voltage measuring unit 8 by the CPU 62 varies somewhat depending on the current value, so that the voltage value can be corrected by obtaining a correction coefficient through the experiment.

A result in which a difference is compared between the SOC estimation based on the voltage reference of the present embodiment and the SOC estimation based on the conventional current integration during the repetition of the charge-discharge will be described below.

Fig. 12 is a graph illustrating the transition of the voltage value with respect to time during the charge-discharge. The horizontal axis indicates time (second), and the vertical axis indicates a charge-discharge voltage value (VvsLi/Li⁺). Because the charge-discharge is performed by a minute electric current in the first embodiment, it is checked that the voltage value during energization indicates the substantially same value as the OCV.

As illustrated in Fig. 12, the first charge was performed, the voltage value exceeded the lower limit voltage value E0 V and reached E3 V, and the first discharge was performed. After the voltage value reached E0 V, the second charge was performed, the voltage value reached E1 V, and the second discharge was performed.

E3 V is stored as the first reached voltage value in the memory 63. The reached voltage value is updated at a point of time the voltage value exceeds E3 V during the second charge. The SOC-OCV curve d is used until the voltage value reaches E3 V in the first discharge and the second charge. Another SOC-OCV curve stored in the table 63b is used between E3 V and E1 V of the second charge. The SOC-OCV curve b is used from E1 V of the second discharge to E0 V of the lower limit voltage value.

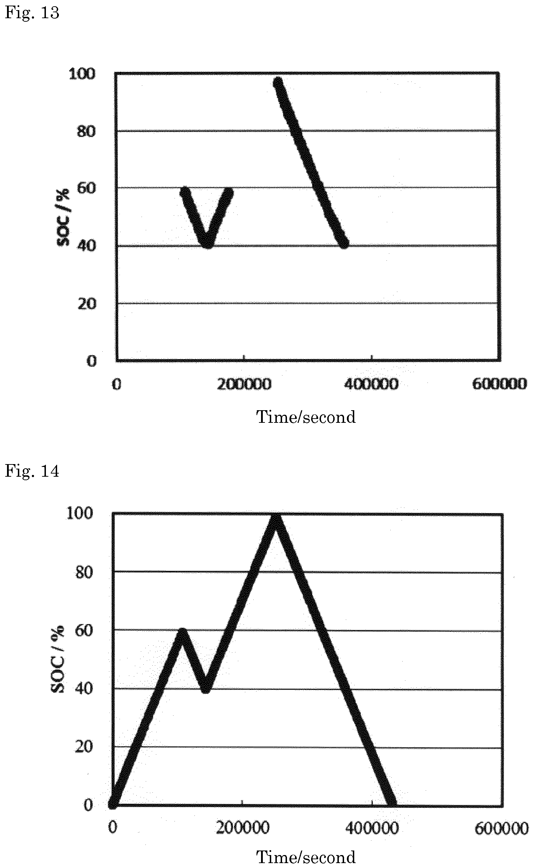

Fig. 13 is a graph which illustrating the transition of the SOC calculated by the voltage reference until the voltage value reaches E3 V in the first discharge and the second charge, and until the voltage value changes from E3 V of the second discharge to the lower limit voltage E0 V.

Fig. 14 is a graph illustrating the transition of the SOC when the SOC is calculated by the current integration in the transition of the charge-discharge voltage value in Fig. 12.

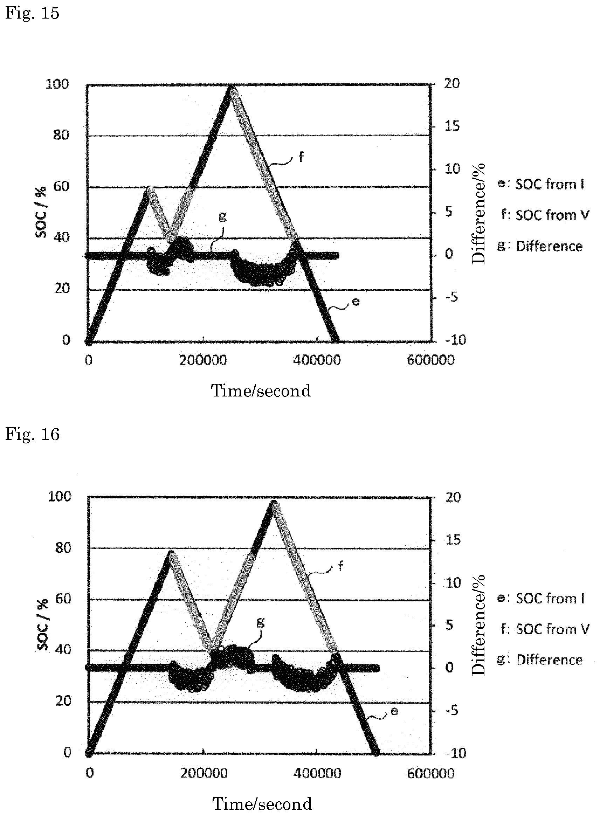

Fig. 15 is a graph illustrating a difference between the estimation of the SOC by the voltage reference of the first embodiment and the estimation of the SOC by the conventional current integration when the charge-discharge in Fig. 12 is performed on the battery 3 of an initial product. The horizontal axis indicates time (second), the left vertical axis indicates SOC (%), and the right vertical axis indicates the difference (%). In the estimation of the SOC by the current integration as a control, the discharge capacity is previously checked and a highly accurate ammeter is used, so that the discharge capacity of Q and the current value of I in equation (1) are accurate. It is considered that the discharge capacity of Q and the current value of I approximate the true values.

In the drawings, e is the transition of the SOC obtained by the current integration, f is the transition of the SOC obtained by the voltage reference using the SOC-OCV curves d and b, and g is the difference. The difference was obtained by (SOC calculated by voltage reference) - (SOC calculated by current integration).

As can be seen from Fig. 15, the difference is less than about ±4% and is small.

Fig. 16 is a graph illustrating the difference between the estimation of the SOC by the voltage reference and the estimation of the SOC by the current integration when the charge-discharge is performed with a pattern different from one in Fig. 12 on the battery 3 of the initial product. The horizontal axis indicates time (second), the left vertical axis indicates SOC (%), and the right vertical axis indicates the difference (%).

In Fig. 16, e is the transition of the SOC obtained by the current integration, f is the transition of the SOC obtained by the voltage reference using the SOC-OCV curves c and b, and g is the difference.

As can be seen from Fig. 16, the difference is less than about ±3% and is small.

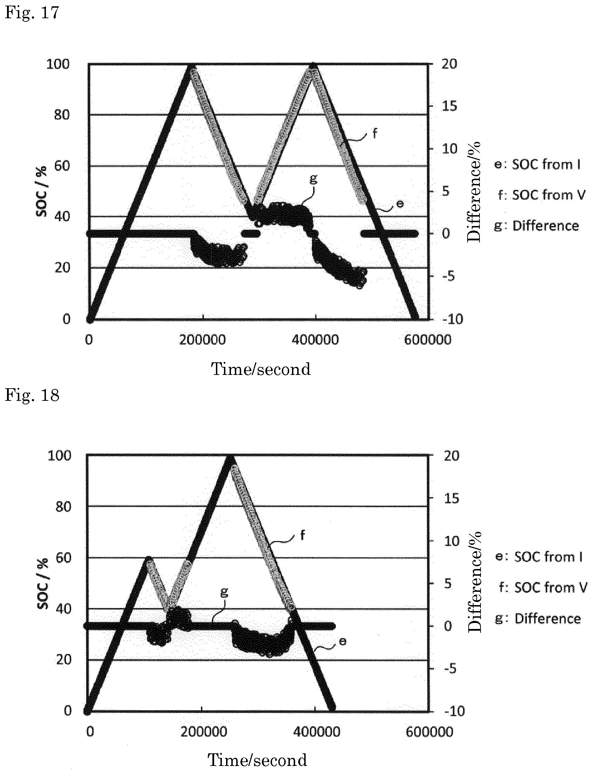

Fig. 17 is a graph illustrating the difference between the estimation of the SOC by the voltage reference and the estimation of the SOC by the current integration when the charge-discharge is performed with the pattern different from one in Fig. 12 on the battery 3 of the initial product. The horizontal axis indicates time (second), the left vertical axis indicates SOC (%), and the right vertical axis indicates the difference (%).

In Fig. 17, e is the transition of the SOC obtained by the current integration, f is the transition of the SOC obtained by the voltage reference using the SOC-OCV curve b, and g is the difference.

As can be seen from Fig. 17, the difference is less than about ±5% and is small.

From the above, it was confirmed that the error is small between the estimation of the SOC by the voltage reference of the first embodiment and the estimation of the SOC by the current integration of the control, and the estimation of the SOC by the voltage reference of the first embodiment has high accuracy.

Fig. 18 is a graph illustrating the difference between the estimation of the SOC by the voltage reference and the estimation of the SOC by the current integration when the charge-discharge in Fig. 12 is performed on the battery 3 of a degraded product. The horizontal axis indicates time (second), the left vertical axis indicates SOC (%), and the right vertical axis indicates the difference (%). In the table 63b, the SOC-OCV curve of the degraded product is also obtained by the experiment and stored. Alternatively, as described above, the SOC-OCV curve is updated at predetermined time intervals.

In Fig. 18, e is the transition of the SOC obtained by the current integration, f is the transition of the SOC obtained by the voltage reference using the SOC-OCV curve of the degraded product, and g is the difference.

As can be seen from Fig. 18, the difference is less than about ±4% and is small.

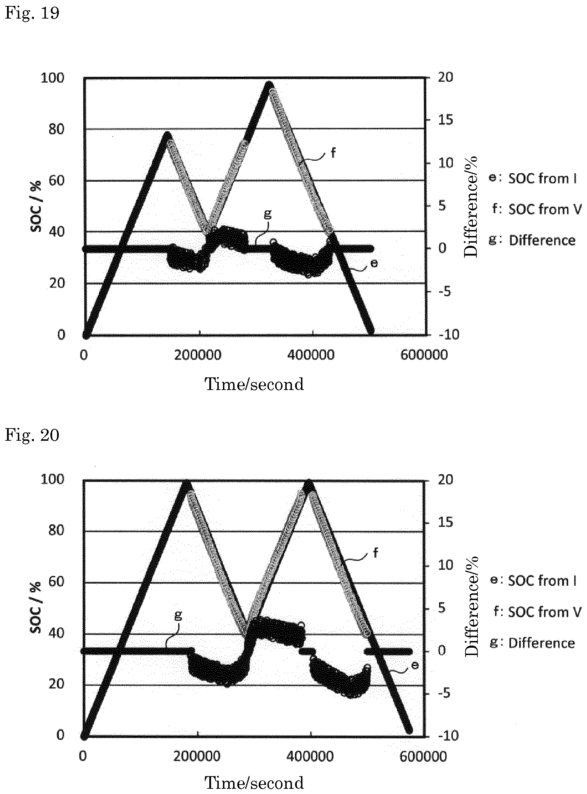

Fig. 19 is a graph illustrating the difference between the estimation of the SOC by the voltage reference and the estimation of the SOC by the current integration when the charge-discharge is performed with the pattern identical to one in Fig. 16 on the battery 3 of the degraded product. The horizontal axis indicates time (second), the left vertical axis indicates SOC (%), and the right vertical axis indicates the difference (%).

In Fig. 18, e is the transition of the SOC obtained by the current integration, f is the transition of the SOC obtained by the voltage reference using the SOC-OCV curve of the degraded product, and g is the difference.

As can be seen from Fig. 19, the difference is less than about ±4% and is small.

Fig. 20 is a graph illustrating the difference between the estimation of the SOC by the voltage reference and the estimation of the SOC by the current integration when the charge-discharge is performed with the pattern identical to one in Fig. 17 on the battery 3 of the degraded product. The horizontal axis indicates time (second), the left vertical axis indicates SOC (%), and the right vertical axis indicates the difference (%).

In Fig. 18, e is the transition of the SOC obtained by the current integration, f is the transition of the SOC obtained by the voltage reference using the SOC-OCV curve of the degraded product, and g is the difference.

As can be seen from Fig. 20, the difference is less than about ±5% and is small.

From the above, even in the battery 3 of the degraded product, it was confirmed that the error is small between the estimation of the SOC by the voltage reference of the first embodiment and the estimation of the SOC by the current integration of the control, and the estimation of the SOC by the voltage reference of the first embodiment has high accuracy.

As described above, in the first embodiment, the hysteresis is small (substantially no hysteresis), and the SOC is estimated based on the SOC-OCV curve and the current voltage value in the range from the lower limit voltage value to the reached voltage value, so that the estimation of SOC can be estimated with high accuracy. Thus, the OCV reset can be performed with high accuracy.

The SOC can be estimated in both the charge and the discharge. The selection of the SOC-OCV curve based on the set reached voltage value can estimate the SOC only from a history of the voltage value, when the charge-discharge is repeated in a complicated pattern. Only when the acquired voltage value exceeds the previous reached voltage value, the update of the reached voltage value can accurately estimate the SOC as compared with Patent Document 1 that selects the SOC-OCV curve based on the final voltage value during the charge.

Because the SOC can be estimated from the SOC-OCV curve, the storage amount is not limited to the SOC, but the current amount of energy, such as amount of power, which is stored in the battery 3, can be estimated.

Only three SOC-OCV curves corresponding to different reached voltage values are used in the above comparative experiment. When the charge is performed from the reached voltage value to the voltage value of SOC 100%, the SOC cannot be calculated by the voltage reference. As described above, the SOC-OCV curves corresponding to all the reached voltage values are continuously stored in the table 63b, or the SOC-OCV curve between the SOC-OCV curves is calculated by the interpolation, which allows the SOC to also be estimated by the voltage reference.

When the interval at which the voltage value and the current value are acquired in S1 is a low frequency, the SOC can be estimated by calculating the SOC-OCV curve between the SOC-OCV curves with no use of many SOC-OCV curves.

When the interval at which the voltage value and current value are acquired in S1 is a high frequency, preferably many SOC-OCV curves are stored in the table 63b. In this case, the SOC can be estimated with high accuracy.

(Second embodiment)

The case where the SOC is estimated in real time will be described in a second embodiment. The configuration is the same as that of the first embodiment except for the SOC estimation processing performed by the CPU 62.

The SOC estimation processing performed by the CPU 62 of the second embodiment will be described below.

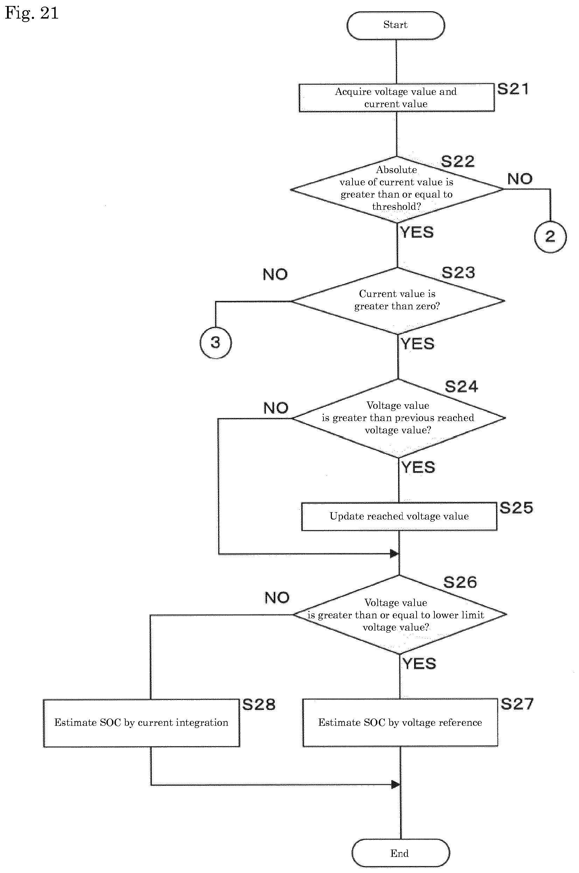

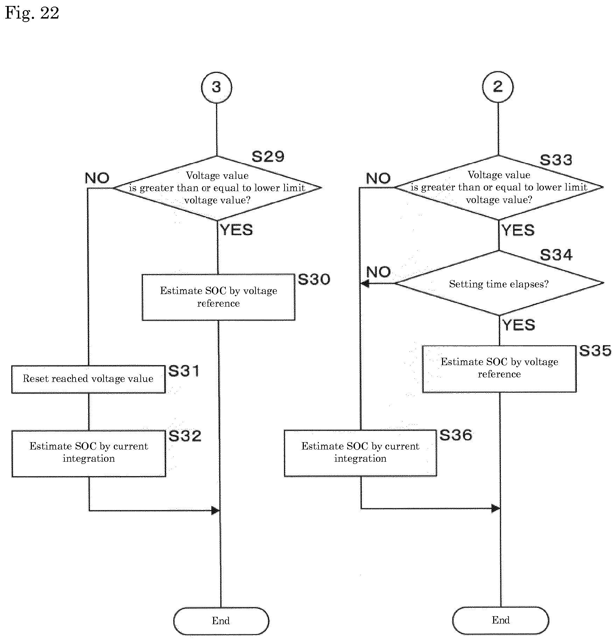

Figs. 21 and 22 are a flowchart illustrating the procedure of the SOC estimation process performed by the CPU 62. The CPU 62 repeats the pieces of processing from S21 at predetermined intervals.

The CPU 62 acquires the voltage value and the current value between the terminals of the battery 3 (S21).

The CPU 62 determines whether the absolute value of the current value is greater than or equal to a threshold (S22). The threshold is set in order to determine whether the battery 3 is in a charge state, a discharge state, or a resting state. When the CPU 62 determines that the absolute value of the current value is less than the threshold (NO in S22), the processing proceeds to S33.

When determining that the absolute value of the current value is greater than or equal to the threshold (YES in S22), the CPU 62 determines whether the current value is greater than zero (S23). When the current value is larger than zero, the battery 3 is in the charge state. When the CPU 62 determines that the current value is not greater than zero (NO in S23), the processing proceeds to S29.

When determining that the current value is greater than zero (YES in S23), the CPU 62 determines whether the voltage value is greater than the previous reached voltage value (S24). When the CPU 62 determines that the voltage value is not greater than the previous reached voltage value (NO in S24), the processing proceeds to S26.

When determining that the voltage value is larger than the previous reached voltage value (YES in S24), the CPU 62 updates the voltage value to the reached voltage value (S25).

The CPU 62 determines whether the voltage value is greater than or equal to the lower limit voltage value (S26). When determining that the voltage value is less than the lower limit voltage value (NO in S26), the CPU 62 estimates the SOC by the current integration (S28), and ends the processing.

When determining that the voltage value is greater than or equal to the lower limit voltage value (YES in S26), the CPU 62 estimates the SOC by the voltage reference (S27), and ends the processing.

The table 63b stores a plurality of SOCOCV curves from the lower limit voltage to a plurality of reached voltages. The CPU 62 selects the SOC-OCV curve corresponding to the stored reached voltage value, and reads the SOC from the current OCV in the SOC-OCV curve. The CPU 62 calculates the current OCV from the voltage value and the current value acquired in S21. The OCV can be calculated by estimating the voltage value at the current value of zero using the regression line from the data of the pluralities of voltage values and current values. When the current value is as small as the dark current value, the acquired voltage value can be read as the OCV.

When determining that the current value is smaller than zero and the battery 3 is in the discharge state, the CPU 62 determines whether the voltage value is greater than or equal to the lower limit voltage value in S29 (S29).

When determining that the voltage value is greater than or equal to the lower limit voltage value (YES in S29), the CPU 62 estimates the SOC by the voltage reference in the same manner as described above (S30).

When determining that the voltage value is less than the lower limit voltage value (NO in S29), the CPU 62 resets the reached voltage value (S31).

The CPU 62 estimates the SOC by the current integration (S32), and ends the processing.

When determining that the absolute value of the current value is less than the threshold and the battery 3 is in the resting state, the CPU 62 determines whether the voltage value is greater than or equal to the lower limit voltage value (S33). When the CPU 62 determines that the voltage value is less than the lower limit voltage value (NO in S33), the processing proceeds to S36.

When determining that the voltage value is greater than or equal to the lower limit voltage value (YES in S33), the CPU 62 determines whether the setting time elapses since the battery 3 is determined to be in the resting state in S22 (S34). As for the setting time, a sufficient time for considering the acquired voltage value as the OCV is previously obtained by an experiment.

When the CPU 62 determines that the setting time does not elapse (NO in S34), the processing proceeds to S36.

The CPU 62 estimates the SOC by the current integration (S36), and ends the processing.

When the CPU 62 determines that the setting time elapses (YES in S34), the acquired voltage value can be regarded as the OCV, the SOC is estimated by the voltage reference in the same manner as described above (S35), and the processing is ended.

In the second embodiment, the SOC can be estimated in real time during the charge-discharge.

In the second embodiment, the SOC is estimated based on the SOC-OCV curve and the current voltage value in the range from the lower limit voltage value to the reached voltage value, the hysteresis being substantially free in the range. Thus, the SOC is accurately estimated.

The SOC can be estimated in both the charge and the discharge. Even if the charge-discharge are repeated with the complicated pattern, the SOC can be estimated based only on the history of the voltage values.

Because of the use of the voltage value, the storage amount is not limited to the SOC, and the current amount of energy, such as amount of power, which is stored in the battery 3, can be estimated.

As described above, a storage amount estimation device that estimates a storage amount of an energy storage device in which at least one of a positive electrode and a negative electrode contains an active material, at least two electrochemical reactions being generated in the active material depending on a transition of charge-discharge, a hysteresis of a storage amount-voltage value characteristic indicated during generation of one of the electrochemical reactions is smaller than a hysteresis during generation of the other electrochemical reaction in the active material, the storage amount estimation device includes an estimator that estimates the storage amount based on the storage amount-voltage value characteristic when the one electrochemical reaction is generated more than the other electrochemical reaction.

The storage amount estimation device estimates the storage amount based on the storage amount-voltage value characteristic when one electrochemical reaction is generated (mainly) more than the other electrochemical reaction, the change of the voltage value with respect to the storage amount being substantially the same between the charge and the discharge in one electrochemical reaction. Thus, the storage amount is accurately estimated. The storage amount of the high-capacity energy storage device containing the active material in which the storage amount-voltage value characteristic exhibits the hysteresis can be estimated well.

The storage amount can be estimated in both the charge and the discharge. Even if the charge-discharge are repeated with the complicated pattern, the storage amount can be estimated based only on the history of the voltage values.

Because of the use of the voltage value, the storage amount is not limited to the SOC, and the current amount of energy, such as amount of power, which is stored in the energy storage device, can be estimated. The dischargeable energy up to SOC 0% and the charge energy required up to SOC 100% can be predicted based on the charge-discharge curve.

In the above-described storage amount estimation device, preferably the storage amount-voltage value characteristic includes a first region on a side where the charged amount is relatively high and a second region on a side where the storage amount is relatively low, and the estimator estimates the storage amount based on a storage amount-voltage value characteristic of the first region.

In the second region having a relatively low storage amount, the other electrochemical reaction is easily generated, and the storage amount-voltage value characteristic exhibits the hysteresis. In the above configuration, the storage amount is estimated based on the storage amount-voltage value characteristic of the first region on the side where the storage amount is relatively high, so that the estimation accuracy is good.

A storage amount estimation device that estimates a storage amount of an energy storage device containing an active material in which a storage amount-voltage value characteristic exhibits a hysteresis, the storage amount estimation device includes: a holding unit that holds a plurality of storage amount-voltage value characteristics from a lower limit voltage value, at which existence of the hysteresis is substantially switched, to a plurality of reached voltage values; a voltage acquisition unit that acquires a voltage value of the energy storage device; a setting unit that sets a reached voltage value after the voltage value acquired by the voltage acquisition unit exceeds the lower limit voltage value; a selector that selects one storage amount-voltage value characteristic based on the reached voltage value set by the setting unit; and an estimator that estimates the storage amount based on the one storage amount-voltage value characteristic and the voltage value acquired by the voltage acquisition unit.

The storage amount estimation device estimates the storage amount based on the storage amount-voltage value characteristic and the acquired voltage value in the range from the lower limit voltage value to the reached voltage value, the hysteresis being substantially free in the range. The reaction having the large hysteresis and the reaction that does not substantially have the hysteresis (small hysteresis) are substantially independently generated in the energy storage device in which the electrode material having the hysteresis is used. These reactions do not interfere with each other. As long as the voltage value does not exceed the reached voltage value, the charge and the discharge are performed along a unique curve between the lower limit voltage value and the reached voltage value. Thus, the storage amount is accurately estimated.

The storage amount can be estimated in both the charge and the discharge. Based on the increase or decrease of the voltage value, the reached voltage value is set to select the storage amount-voltage value characteristic. Even if the charge-discharge is repeated with the complicated pattern, the storage amount can be estimated based only on the history of the voltage values.

Because of the use of the voltage value, the storage amount is not limited to the SOC, and the current amount of energy, such as amount of power, which is stored in the energy storage device, can be estimated.

In the storage amount estimation device, preferably the setting unit stores the reached voltage value in a storage unit, and updates the acquired voltage value to the reached voltage value when the voltage value acquired by the voltage acquisition unit is larger than the reached voltage value previously stored in the storage unit.

The storage amount estimation device can accurately estimate the storage amount based on the acquired voltage value by selecting the storage amount-voltage value characteristic based on the larger reached voltage value (updated reached voltage value).

In the storage amount estimation device, the voltage value may be an open-circuit voltage value.

For example, when the energy storage device is inactive to be able to acquire the open circuit voltage value, the storage amount can easily be estimated based on the open circuit voltage value and the storage amount-open-circuit voltage characteristic. When the current value is large during the energization, the storage amount can be estimated by the voltage reference even in the energization by correcting the voltage value to the open circuit voltage value.

In the storage amount estimation device, the voltage value may be a voltage value during passage of a minute current through the energy storage device.

When the voltage value at which the current value is small is regarded as the open circuit voltage value, the storage amount can easily be estimated from the voltage value, and the storage amount can be estimated even in the charge-discharge of the energy storage device.

In the storage amount estimation device, preferably the storage amount is an SOC.

The estimation of the SOC for a high-capacity material improves applicability to the existing control system. Based on the SOC, the storage amount such as the dischargeable energy can easily be calculated. The storage amount estimation device can accurately estimate the charge state of the energy storage device in which the electrode material having the hysteresis is used with no use of a special sensor or additional component, the OCV and the SOC not corresponding to each other on a one-to-one manner in the electrode material.

The energy storage module includes a plurality of energy storage devices and any one of the above storage amount estimation devices.

In the energy storage module for the vehicle or the industrial energy storage module, typically the plurality of energy storage devices are connected in series. Sometimes the plurality of energy storage devices are connected in series and in parallel. In order to exert the performance of the energy storage module, it is necessary to accurately estimate the SOC of each energy storage device, and to perform balancing processing when a variation in SOC is generated among the plurality of energy storage devices. Even if each energy storage device has the high capacity, the performance of the energy storage module cannot be utilized to the fullest unless the variation in SOC among the plurality of energy storage devices can be detected. The SOC of each energy storage device is accurately estimated by the storage amount estimation device, so that the performance of the energy storage module can be exerted at the maximum. The energy storage module is suitably used as a power source for an EV or a PHEV that has a particularly high demand for the high capacity.

A storage amount estimation method for estimating a storage amount of an energy storage device containing an active material in which a storage amount-voltage value characteristic exhibits a hysteresis, the storage amount estimation method includes: holding a plurality of storage amount-voltage value characteristics from a lower limit voltage value, at which existence of the hysteresis is substantially switched, to a plurality of reached voltage values; setting a reached voltage value after an acquired voltage value exceeds the lower limit voltage value; selecting one storage amount-voltage value characteristic based on the set reached voltage value; and estimating the storage amount based on the one storage amount-voltage value characteristic and the acquired voltage value.

In the above method, the storage amount is estimated based on the storage amount-voltage value characteristic and the acquired voltage value in the range from the lower limit voltage value to the reached voltage value, the hysteresis being substantially free in the range. Thus, the storage amount is accurately estimated. The storage amount of the high-capacity energy storage device containing the active material in which the storage amount-voltage value characteristic exhibits the hysteresis can be estimated well.

The storage amount can be estimated in both the charge and the discharge. The inflection point relating to the increase or decrease of the voltage value is set to the reached voltage value to select the storage amount-voltage value characteristic. Even if the charge-discharge are repeated with the complicated pattern, the storage amount can be estimated based only on the history of the voltage values.

Because of the use of the voltage value, the storage amount is not limited to the SOC, and the current amount of energy, such as amount of power, which is stored in the energy storage device, can be estimated.

A computer program causes a computer, which estimates a storage amount of an energy storage device containing an active material in which a storage amount-voltage value characteristic exhibits a hysteresis, to perform: acquiring a voltage value of the energy storage device; determining whether the acquired voltage value exceeds a lower limit voltage value, at which existence of the hysteresis is substantially switched; setting a reached voltage value when the voltage value is determined to exceed the lower limit voltage value; selecting one storage amount-voltage value characteristic by referring to a plurality of storage amount-voltage value characteristics from the lower limit voltage value to a plurality of reached voltage values based on the set reached voltage value; and estimating the storage amount based on the one storage amount-voltage value characteristic and the acquired voltage value.

The storage amount estimation device of the present invention is not limited to the case where the storage amount estimation device is applied to a vehicle-mounted lithium ion secondary battery, but can also be applied to other energy storage modules such as a railway regeneration power storage device and a solar power generating system. In the energy storage module through which the minute current is passed, the voltage value between the positive electrode terminal and the negative electrode terminal of the energy storage device or the voltage value between the positive electrode terminal and the negative electrode terminal of the energy storage module can be regarded as the OCV.

The energy storage device is not limited to the lithium ion secondary battery, but may be another secondary battery or an electrochemical cell having the hysteresis characteristic.

It is not limited to the case where the monitoring device 100 or the BMU 6 is the storage amount estimation device. A CMU (Cell Monitoring Unit) may be the storage amount estimation device. The storage amount estimation device may be a part of the energy storage module in which the monitoring device 100 or the like is incorporated. The storage amount estimation device may be configured separately from the energy storage device or the energy storage module, and connected to the energy storage module including the energy storage device that is the estimation target of the energy storage amount during the estimation of the energy storage amount. The storage amount estimation device may remotely monitor the energy storage device and the energy storage module.

DESCRIPTION OF REFERENCE SIGNS

1, 50 battery module (energy storage module)
2 case
21 case body
22 lid
23 BMU housing
24 cover
25 inner lid
26 partition plate
3, 200 battery (energy storage device)
31 case
32 terminal
33 electrode assembly
4 bus bar
5 external terminal
6 BMU (storage amount estimation device)
60 information processor
62 CPU (estimator, voltage acquisition unit, setting unit, selector)
63 memory (holding unit, storage unit)
63a SOC estimation program

63b table
7 current sensor
8 voltage measuring unit
9 current measurement unit
10 ECU
70 recoding media
100 monitoring device (storage amount estimation device)
300 housing case

## Claims

1. A storage amount estimation device (6) that is configured to estimate an electricity storage amount of an energy storage device (3), wherein at least one of a positive electrode plate and a negative electrode plate of the energy storage device (3) includes an active material, wherein the active material generates at least two electrochemical reactions (A, B) depending on a change of state of charge, and wherein a hysteresis of a voltage value depending on a charge and discharge history in an electricity storage amount-voltage value characteristic during generation of one of the electrochemical reactions (B) is smaller than a hysteresis of the voltage value during generation of the other electrochemical reaction (A) in the active material, the storage amount estimation device comprising:

   a holding unit (63b) that is configured to hold a plurality of electricity storage amount-voltage value characteristics from a lower limit voltage value of a voltage value region, where the reaction amount of the one electrochemical reaction (B) is larger than the reaction amount of the other electrochemical reaction (A), to a plurality of reached voltage values; and
   a processing unit (62) that is configured to:

   • acquire a voltage value of the energy storage device (3);
   • set a reached voltage value, when it is determined that the acquired voltage value exceeds the lower limit voltage value, wherein the reached voltage value is a maximum voltage value that has been acquired during charging of the energy storage device;
   • select one electricity storage amount-voltage value characteristic based on the set reached voltage value; and
   • estimate the electricity storage amount based on the selected one electricity storage amount-voltage value characteristic and the voltage value acquired by the voltage acquisition unit (8).

**2.** The storage amount estimation device (6) according to claim 1, wherein the processing unit (62) is further configured to:

- store the reached voltage value in the storage unit (63), and
- update the acquired voltage value to the reached voltage value when the voltage value acquired by the voltage acquisition unit (8) is larger than the ultimate voltage value previously stored in the storage unit (63).

**3.** The storage amount estimation device (6) according to any one of claims 1 or 2, wherein the voltage value is an open circuit voltage value.

**4.** The storage amount estimation device (6) according to any one of claims 1 or 2, wherein the voltage value is a voltage value, acquired during passage of a current, which is smaller than a predetermined threshold, through the energy storage device.

**5.** An energy storage module (1) comprising:

a plurality of energy storage devices (3); and the storage amount estimation device (6) according to any one of claims 1 to 4.

**6.** A storage amount estimation method for estimating an electricity storage amount of an energy storage device (3), wherein all the steps of the method are carried out by the storage amount estimation device (6) according to any of claims 1 to 4 or by a computer, wherein at least one of a positive electrode plate and a negative electrode plate of the energy storage device (3) includes an active material, wherein the active material generates at least two electrochemical reactions (A, B) depending on a change of state of charge, and wherein a hysteresis of a voltage value depending on a charge and discharge history in an electricity storage amount-voltage value characteristic during generation of one of the electrochemical reactions (B) is smaller than a hysteresis of the voltage value during generation of the other electrochemical reaction (A) in the active material, the storage amount estimation method comprising:

holding a plurality of electricity storage amount-voltage value characteristics from a lower limit voltage value of a voltage value region, where the reaction amount of the one electrochemical reaction (B) is larger than the reaction amount of the other electrochemical reaction (A), to a plurality of reached voltage values;
acquiring a voltage value of the energy storage device (3);
setting a reached voltage value, when it is determined that the acquired voltage value exceeds the lower limit voltage value, wherein the reached voltage value is a maximum voltage value that has been acquired during charging of the energy storage device;
selecting one electricity storage amount-voltage value characteristic based on the set reached voltage value; and
estimating the electricity storage amount based on the selected one electricity storage amount-voltage value characteristic and the acquired voltage value.

**7.** A computer program causing a computer, which is configured to estimate an electricity storage amount of an energy storage device (3), wherein at least one of a positive electrode plate and a negative electrode plate of the energy storage device (3) includes an active material, wherein the active material generates at least two electrochemical reactions (A, B) depending on a change of state of charge, and wherein a hysteresis of a voltage value depending on a charge and discharge history in an electricity storage amount-voltage value characteristic during generation of one of the electrochemical reactions (B) is smaller than a hysteresis of the voltage value during generation of the other electrochemical reaction (A) in the active material in which an electricity storage amount-voltage value characteristic exhibits a hysteresis, to perform the steps of the method according to claim 6.

**Patentansprüche**

**1.** Vorrichtung (6) für Schätzung einer Speicherungsmenge, die so ausgeführt ist, dass sie eine Strom-Speicherungsmenge einer Energiespeicherungsvorrichtung (3) schätzt, wobei eine positive Elektrodenplatte oder/und eine negative Elektrodenplatte der Energiespeicherungsvorrichtung (3) ein aktives Material enthält/enthalten, wobei das aktive Material, je nach einem Änderungszustand von Ladung, wenigstens zwei elektrochemische Reaktionen (A, B) erzeugt, und eine Hysterese eines Spannungswertes in Abhängigkeit von einem Lade-und-Entlade-Verlauf in einer Strom-Speicherungsmengen-Spannungswert-Kennlinie bei Erzeugung einer der elektrochemischen Reaktionen (B) kleiner ist als eine Hysterese des Spannungswertes bei Erzeugung der anderen elektrochemischen Reaktion (A) in dem aktiven Material, wobei die Vorrichtung für Schätzung einer Speicherungsmenge umfasst:

eine Halte-Einheit (63b), die so ausgeführt ist, dass sie eine Vielzahl von Strom-Speicherungsmengen-Spannungswert-Kennlinien von einem unteren Grenz-Spannungswert eines Spannungswert-Bereiches, in dem der Reaktions-Betrag der einen elektrochemischen Reaktion (B) größer ist als der Reaktions-Betrag der anderen elektrochemischen Reaktion (A), bis zu einer Vielzahl erreichter Spannungswerte hält; und

eine Verarbeitungs-Einheit (62), die ausgeführt ist zum:

• Erfassen eines Spannungswertes der Energiespeicherungsvorrichtung (3);
• Einstellen eines erreichten Spannungswertes, wenn festgestellt wird, dass der erfasste Spannungswert den unteren Grenz-Spannungswert überschreitet, wobei der erreichte Spannungswert ein maximaler Spannungswert ist, der beim Laden der Energiespeicherungsvorrichtung erfasst worden ist;
• Auswählen einer Strom-Speicherungsmengen-Spannungswert-Kennlinie auf Basis des eingestellten erreichten Spannungswertes; sowie
• Schätzen der Strom-Speicherungsmenge auf Basis der ausgewählten Strom-Speicherungsmengen-Spannungswert-Kennlinie sowie des durch die Spannungserfassungs-Einheit (8) erfassten Spannungswertes.

2. Vorrichtung (6) für Schätzung einer Speicherungsmenge nach Anspruch 1, wobei die Verarbeitungs-Einheit (62) des Weiteren ausgeführt ist zum:

• Speichern des erreichten Spannungswertes in der Speicherungs-Einheit (63), sowie
• Aktualisieren des erfassten Spannungswertes auf den erreichten Spannungswert, wenn der durch die Spannungserfassungs-Einheit (8) erfasste Spannungswert größer ist als der letzte zuvor in der Speicherungs-Einheit (63) gespeicherte Spannungswert.

3. Vorrichtung (6) für Schätzung einer Speicherungsmenge nach einem der Ansprüche 1 oder 2, wobei der Spannungswert ein Leerlauf-Spannungswert ist.

4. Vorrichtung (6) für Schätzung einer Speicherungsmenge nach einem der Ansprüche 1 oder 2, wobei der Spannungswert ein bei Durchgang eines Stroms, der unter einem vorgegebenen Schwellenwert liegt, durch die Energiespeicherungsvorrichtung erfasster Spannungswert ist.

5. Energiespeicherungs-Modul (1), das umfasst:

eine Vielzahl von Energiespeicherungsvorrichtungen (3); und
die Vorrichtung (6) für Schätzung einer Speicherungsmenge nach einem der Ansprüche 1 bis 4.

6. Verfahren für Schätzung einer Speicherungsmenge, mit dem eine Strom-Speicherungsmenge einer Energiespeicherungsvorrichtung (3) geschätzt wird, wobei alle der Schritte des Verfahrens von der Vorrichtung (6) für Schätzung einer Speicherungsmenge nach einem der Ansprüche 1 bis 4 oder von einem Computer ausgeführt werden, wobei eine positive Elektrodenplatte oder/und eine negative Elektrodenplatte der Energiespeicherungsvorrichtung (3) ein aktives Material enthält/enthalten, wobei das aktive Material, je nach einem Änderungszustand von Ladung, wenigstens zwei elektrochemische Reaktionen (A, B) erzeugt, und eine Hysterese eines Spannungswertes in Abhängigkeit von einem Lade-und-Entlade-Verlauf in einer Strom-Speicherungsmengen-Spannungswert-Kennlinie bei Erzeugung einer der elektrochemischen Reaktionen (B) kleiner ist als eine Hysterese des Spannungswertes bei Erzeugung der anderen elektrochemischen Reaktion (A) in dem aktiven Material, wobei das Verfahren für Schätzung einer Speicherungsmenge umfasst:

Halten einer Vielzahl von Strom-Speicherungsmengen-Spannungswert-Kennlinien von einem unteren Grenz-Spannungswert eines Spannungswert-Bereiches, in dem der Reaktions-Betrag der einen elektrochemischen Reaktion (B) größer ist als ein Reaktions-Betrag der anderen elektrochemischen Reaktion (A), bis zu einer Vielzahl erreichter Spannungswerte;
Erfassen eines Spannungswertes der Energiespeicherungsvorrichtung (3);
Einstellen eines erreichten Spannungswertes, wenn festgestellt wird, dass der erfasste Spannungswert den unteren Grenz-Spannungswert überschreitet, wobei der erreichte Spannungswert ein maximaler Spannungswert ist, der beim Laden der Energiespeicherungsvorrichtung erfasst worden ist;
Auswählen einer Strom-Speicherungsmengen-Spannungswert-Kennlinie auf Basis des eingestellten erreichten Spannungswertes; sowie
Schätzen der Strom-Speicherungsmenge auf Basis der ausgewählten einen Strom-Speicherungsmengen-Spannungswert-Kennlinie sowie des erfassten Spannungswertes.

7. Computerprogramm, das einen Computer, der zum Schätzen einer Strom-Speicherungsmenge einer Energiespeicherungsvorrichtung (3) ausgeführt ist, veranlasst, die Schritte des Verfahrens nach Anspruch 6 durchzuführen, wobei eine positive Elektrodenplatte oder/und eine negative Elektrodenplatte der Energiespeicherungsvorrichtung (3) ein aktives Material enthält/enthalten, wobei das aktive Material, je nach einem Änderungszustand von Ladung, wenigstens zwei elektrochemische Reaktionen (A, B) erzeugt, und eine Hysterese eines Spannungswertes in Abhängigkeit von einem Lade-und-Entlade-Verlauf in einer Strom-Speicherungsmengen-Spannungswert-Kennlinie bei Erzeugung einer der elektrochemischen Reaktionen (B) kleiner ist als eine Hysterese des Spannungswertes bei Erzeugung der anderen elektrochemischen Reaktion (A) in dem aktiven Material, in dem eine Strom-Speicherungsmengen-Spannungswert-Kennlinie eine Hysterese aufweist.

## Revendications

1. Dispositif d'estimation de quantité de stockage (6) qui est configuré pour estimer une quantité de stockage d'électricité d'un dispositif de stockage d'énergie (3), dans lequel au moins une plaque d'électrode parmi une plaque d'électrode positive et une plaque d'électrode négative du dispositif de stockage d'énergie (3) inclut un matériau actif, dans lequel le matériau actif génère au moins deux réactions électrochimiques (A, B) en fonction d'un changement d'état de charge, et dans lequel une hystérésis d'une valeur de tension en fonction d'un historique de charge et de décharge au niveau d'une caractéristique quantité de stockage d'électricité-valeur de tension pendant la génération de l'une des réactions électrochimiques (B) est plus petite qu'une hystérésis de la valeur de tension pendant la génération de l'autre réaction électrochimique (A) dans le matériau actif, le dispositif d'estimation de quantité de stockage comprenant :

une unité de maintien (63b) qui est configurée pour maintenir une pluralité de caractéristiques quantité de stockage d'électricité-valeur de tension depuis une valeur de tension de limite inférieure d'une région de valeurs de tension, où la quantité de réaction de la réaction électrochimique considérée en premier (B) est plus grande que la quantité de réaction de l'autre réaction électrochimique (A), jusqu'à une pluralité de valeurs de tension atteintes ; et une unité de traitement (62) qui est configurée pour :

• acquérir une valeur de tension du dispositif de stockage d'énergie (3) ;
• définir une valeur de tension atteinte, lorsqu'il est déterminé que la valeur de tension acquise excède la valeur de tension de limite inférieure, dans lequel la valeur de tension atteinte est une valeur de tension maximum qui a été acquise pendant la charge du dispositif de stockage d'énergie ;

• sélectionner une caractéristique quantité de stockage d'électricité-valeur de tension sur la base de la valeur de tension atteinte définie ; et
• estimer la quantité de stockage d'électricité sur la base de la caractéristique quantité de stockage d'électricité-valeur de tension sélectionnée et de la valeur de tension acquise par l'unité d'acquisition de tension (8).

2. Dispositif d'estimation de quantité de stockage (6) selon la revendication 1, dans lequel l'unité de traitement (62) est en outre configurée pour :

• stocker la valeur de tension atteinte dans l'unité de stockage (63) ; et
• mettre à jour la valeur de tension acquise selon la valeur de tension atteinte lorsque la valeur de tension qui est acquise par l'unité d'acquisition de tension (8) est plus grande que la valeur de tension ultime qui a été stockée au préalable dans l'unité de stockage (63).

3. Dispositif d'estimation de quantité de stockage (6) selon l'une quelconque des revendications 1 ou 2, dans lequel la valeur de tension est une valeur de tension en circuit ouvert.

4. Dispositif d'estimation de quantité de stockage (6) selon l'une quelconque des revendications 1 ou 2, dans lequel la valeur de tension est une valeur de tension, acquise pendant le passage d'un courant, laquelle est inférieure à un seuil prédéterminé, au travers du dispositif de stockage d'énergie.

5. Module de stockage d'énergie (1) comprenant :

une pluralité de dispositifs de stockage d'énergie (3) ; et
le dispositif d'estimation de quantité de stockage (6) selon l'une quelconque des revendications 1 à 4.

6. Procédé d'estimation de quantité de stockage pour estimer une quantité de stockage d'électricité d'un dispositif de stockage d'énergie (3), dans lequel toutes les étapes du procédé sont mises en oeuvre par le dispositif d'estimation de quantité de stockage (6) selon l'une quelconque des revendications 1 à 4 ou par un ordinateur, dans lequel au moins une plaque d'électrode parmi une plaque d'électrode positive et une plaque d'électrode négative du dispositif de stockage d'énergie (3) inclut un matériau actif, dans lequel le matériau actif génère au moins deux réactions électrochimiques (A, B) en fonction d'un changement d'état de charge, et dans lequel une hystérésis d'une valeur de tension en fonction d'un historique de charge et de décharge au niveau d'une caractéristique quantité de stockage d'électricité-valeur de tension pendant la génération de l'une des réactions électrochimiques (B) est plus petite qu'une hystérésis de la valeur de tension pendant la génération de l'autre réaction électrochimique (A) dans le matériau actif, le procédé d'estimation de quantité de stockage comprenant :

le maintien d'une pluralité de caractéristiques quantité de stockage d'électricité-valeur de tension depuis une valeur de tension de limite inférieure d'une région de valeurs de tension, où la quantité de réaction de la réaction électrochimique considérée en premier (B) est plus grande que la quantité de réaction de l'autre réaction électrochimique (A), jusqu'à une pluralité de valeurs de tension atteintes ; et l'acquisition d'une valeur de tension du dispositif de stockage d'énergie (3) ;
la définition d'une valeur de tension atteinte, lorsqu'il est déterminé que la valeur de tension acquise excède la valeur de tension de limite inférieure, dans lequel la valeur de tension atteinte est une valeur de tension maximum qui a été acquise pendant la charge du dispositif de stockage d'énergie ;
la sélection d'une caractéristique quantité de stockage d'électricité-valeur de tension sur la base de la valeur de tension atteinte définie ; et l'estimation de la quantité de stockage d'électricité sur la base de la caractéristique quantité de stockage d'électricité-valeur de tension sélectionnée et de la valeur de tension acquise.

7. Programme informatique forçant un ordinateur, lequel programme est configuré pour estimer une quantité de stockage d'électricité d'un dispositif de stockage d'énergie (3), dans lequel au moins une plaque d'électrode parmi une plaque d'électrode positive et une plaque d'électrode négative du dispositif de stockage d'énergie (3) inclut un matériau actif, dans lequel le matériau actif génère au moins deux réactions électrochimiques (A, B) en fonction d'un changement d'état de charge, et dans lequel une hystérésis d'une valeur de tension en fonction d'un historique de charge et de décharge au niveau d'une caractéristique quantité de stockage d'électricité-valeur de tension pendant la génération de l'une des réactions électrochimiques (B) est plus petite qu'une hystérésis de la valeur de tension pendant la génération de l'autre réaction électrochimique (A) dans le matériau actif où une caractéristique quantité de stockage d'électricité-valeur de tension présente une hystérésis, à réaliser les étapes du procédé selon la revendication 6.

Fig. 1

Fig. 2

Fig. 3

Fig. 4

Fig. 5

Fig. 6

Fig. 7

Fig. 8

Fig. 9

Fig. 10

```
                                    ┌─────────────┐
                                    │    Start    │
                                    └──────┬──────┘
                                           │
                           ┌───────────────────────────────┐ S1
                           │   Acquire voltage value and    │
                           │         current value          │
                           └───────────────┬───────────────┘
                                           │
                                   Absolute      S2
                              value of current value is          NO
                               greater than or equal to  ──────────────┐
                                     threshold?                         │
                                           │ YES                      ┌─┴─┐
                                           │                          │ 1 │
                              Current value is          S3            └───┘
                    NO ───── greater than zero?
                     │                     │ YES
                     │                     │
              Voltage            S9              Voltage          S4
   NO ── value is less than lower limit   NO ── value is greater than or
    │         voltage value?               │   equal to lower limit voltage
    │                │ YES                  │            value?
    │                │                      │              │ YES
    │   ┌─────────────────────────┐ S10     │   ┌─────────────────────────┐ S5
    │   │ Turn off voltage reference flag │  │   │  Turn on voltage reference flag │
    │   └────────────┬────────────┘        │   └────────────┬────────────┘
    │                │                      │                │
    │   ┌─────────────────────────┐ S11     │           Voltage          S6
    │   │  Reset reached voltage value │    │   NO ── value is greater than
    │   └────────────┬────────────┘        │    │   previous reached voltage
    │                │                      │    │          value?
    └────────────────┤                      │    │            │ YES
                     │                      │    │   ┌─────────────────────┐ S7
      ┌─────────────────────────┐ S12       │    │   │ Update reached voltage value │
      │   Estimate SOC by current │         │    │   └──────────┬──────────┘
      │        integration        │         │    └──────────────┤
      └────────────┬────────────┘          └───────────────────┤
                   │                                            │
            ┌──────┴──────┐                      ┌─────────────────────────┐ S8
            │     End     │                      │   Estimate SOC by current │
            └─────────────┘                      │        integration        │
                                                 └────────────┬────────────┘
                                                              │
                                                       ┌──────┴──────┐
                                                       │     End     │
                                                       └─────────────┘
```

Fig. 11

①

S13

Voltage reference flag is
turned on?

NO

YES

S14

Setting time elapses?

NO

YES

S16
Estimate SOC by current
integration

S15
Estimate SOC by voltage
reference

End

Fig. 12

E1

Reached voltage value

E3

E0

Lower limit
voltage value

E / V vs. Li/Li⁺

0    100000   200000   300000   400000   500000

Time/second

Fig. 13

Fig. 14

Fig. 15

Fig. 16

Fig. 17

Fig. 18

Fig. 19

Fig. 20

Fig. 21

Start

Acquire voltage value and current value — S21

Absolute value of current value is greater than or equal to threshold? — S22
NO → (2)
YES

Current value is greater than zero? — S23
NO → (3)
YES

Voltage value is greater than previous reached voltage value? — S24
NO
YES

Update reached voltage value — S25

Voltage value is greater than or equal to lower limit voltage value? — S26
NO
YES

Estimate SOC by current integration — S28

Estimate SOC by voltage reference — S27

End

Fig. 22

③

**S29**
NO — Voltage value is greater than or equal to lower limit voltage value?

YES

Estimate SOC by voltage reference — **S30**

Reset reached voltage value — **S31**

Estimate SOC by current integration — **S32**

End

②

**S33**
NO — Voltage value is greater than or equal to lower limit voltage value?

YES

**S34**
NO — Setting time elapses?

YES

Estimate SOC by voltage reference — **S35**

Estimate SOC by current integration — **S36**

End

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2013105519 A
- US 2006091863 A1
- US 2015355285 A1
- US 2002113595 A1
- US 2016254542 A1
- US 2010213946 A1